# FASCICULE DE BREVET EUROPEEN

(11) **EP 4 111 150 B1**
(45) Date de publication et mention de la délivrance du brevet: **20.11.2024**
(21) Numéro de dépôt: 21710554.3
(22) Date de dépôt: 24.02.2021
(51) Int. Cl.: G01L 1/18, G06F 3/041, G06F 3/044, G06F 3/045, G01D 21/02, G06F 3/01, G01D 5/56

(54) **DISPOSITIF DE COMMANDE DESTINÉ À COMMANDER UNE FONCTION D'UN VÉHICULE AUTOMOBILE**
STEUERVORRICHTUNG ZUR STEUERUNG EINER FUNKTION EINES KRAFTFAHRZEUGS
CONTROL DEVICE INTENDED TO CONTROL A FUNCTION OF A MOTOR VEHICLE

(30) Priorité: 28.02.2020 FR 2002055
(43) Date de publication de la demande: 04.01.2023
(73) Titulaire: NOVARES France, 78140 Vélizy-Villacoublay (FR); Nanomade Lab, 31400 Toulouse (FR)
(72) Inventeur: BOLLIER, François, 06300 Nice (FR); BARBORINI, Vincent, 06200 Nice (FR); SEVERAC, Fabrice, 31300 Toulouse (FR); DUFOUR, Nicolas, 31290 Vallègue (FR)
(74) Mandataire: Germain Maureau
(86) Numéro de dépôt international: PCT/FR2021/050323
(87) Numéro de publication internationale: WO 2021/170956

(56) Documents cités:
- WO-A1-2016/135425
- US-A1- 2007 119 698
- US-A1- 2015 091 859
- US-A1- 2017 357 344

## Description

La présente invention se rapporte au domaine des interfaces de commande des fonctions d'habitacle de véhicule.

La conduite d'un véhicule automobile implique des interactions entre le conducteur et le véhicule et, à ce titre, un véhicule automobile est pourvu de différents organes de commande disséminés dans l'habitacle du véhicule.

Les organes de commandes comprennent traditionnellement des boutons poussoirs ou rotatifs, des curseurs sur lesquels agit le conducteur ou un passager pour piloter des fonctions du véhicule telles que le système d'info-divertissement, l'éclairage, le verrouillage centralisé, la climatisation...

Au cours des dernières années, on a assisté à la transformation des organes de commande essentiellement électromécaniques à base de bouton, switch, micro-switch, potentiomètre, etc... en interface de commande numérique dans lesquels la commande du conducteur ou passager est convertie en un signal électrique qu'un calculateur traite pour agir sur un actuateur qui transcrit l'instruction donnée par le conducteur ou passager.

Les interfaces de commande multifonctions sont utilisées pour commander des systèmes électriques ou électroniques, tels qu'un système de climatisation, un système audio ou encore un système de navigation. Les interfaces de commande peuvent être généralement associées à un écran tactile généralement capacitif et permettent une navigation dans des menus déroulants.

Cependant, en présence de fonctions de plus en plus nombreuses, il est nécessaire d'améliorer l'ergonomie des interfaces homme-machine. Lorsqu'un utilisateur appuie sur la surface tactile, on peut déterminer la localisation de la position par détection de contact ou de la pression où la force est exercée. Dans ce cas, un appui de l'utilisateur est par exemple associé à la sélection d'une commande. En outre, pour signaler à l'utilisateur que sa commande a bien été prise en compte, que cela soit en situation normale de conduite ou d'arrêt mais également en situation dégradée (manipulation en aveugle, charge cognitive importante), il est important que l'utilisateur ait un retour haptique de manière à rester concentré sur la route en diminuant l'effort cognitif associé à la vérification de la réalisation de son action sur la surface tactile.

Pour cela, on connaît déjà des modules de commande dite à retour haptique comportant des actionneurs, tels que des actionneurs électromagnétiques, reliés au module d'interface pour transmettre un mouvement de vibrations, de manière que l'utilisateur perçoive un retour haptique l'informant que sa commande a bien été prise en compte.

Pour permettre de donner à l'utilisateur un retour haptique en adéquation avec son action, il est préférable de détecter à la fois l'action sur la commande et la force de l'action sur la commande. Sur une commande traditionnelle, l'action est actée par un mouvement mécanique. Sur une commande tactile, il convient pour éviter les « fausses détections » de différencier l'intention de l'action. L'intention peut, par exemple, résulter dans le positionnement d'un doigt de l'utilisateur à proximité ou au contact de la commande qu'il veut actionner. Cette intention est généralement détectée au moyen de capteurs capacitifs. L'action consiste au contraire en une pression accentuée sur la commande de manière à déclencher la commande. Cette action peut, par exemple, être détectée par des capteurs sensibles à la pression.

Cette notion d'intention et d'action, en plus d'éviter les fausses détections, est très importante pour donner à l'utilisateur un retour haptique approprié et surtout au bon moment.

En effet, si le retour haptique est envoyé avant que l'utilisateur n'ait produit l'action, son doigt risque de ne pas être en contact suffisant avec la surface de commande pour qu'il perçoive l'effet haptique.

De la même façon, si le retour haptique est envoyé après que l'action ait été produite, l'utilisateur risque d'interpréter une non-prise en charge de son action, voire même d'analyser cela comme un disfonctionnement de son interface de commande.

Pour éviter ces problèmes, il est donc fondamental de proposer des dispositifs de commande permettant de distinguer clairement l'intention et l'action.

Dans les dispositifs de commande actuellement sur le marché, ainsi que dans les dispositifs de commande décrits dans les documents WO 2016/135425 A1, US 2015/091859 A1 et US 2017/357344 A1, cette distinction entre l'intention et l'action s'avère être imparfaitement réalisée.

Ainsi, les dispositifs de commande équipés de capteurs capacitifs uniquement ne permettent pas de différencier l'intention de l'action, du fait que le capteur capacitif déclenche l'action dès qu'il détecte le doigt sur la commande. Par ailleurs, ces capteurs capacitifs ne permettent pas de détecter la force d'appui, et, par conséquent, ne permettent pas de faire varier le retour haptique en adéquation.

Pour pallier ce défaut, il est proposé actuellement de combiner dans un même dispositif de commande des capteurs capacitifs, permettant de détecter l'intention, et des capteurs sensibles à la pression, permettant de détecter l'action.

Parmi les capteurs sensibles à la pression, il existe notamment les micro-switch et les jauges de contraintes.

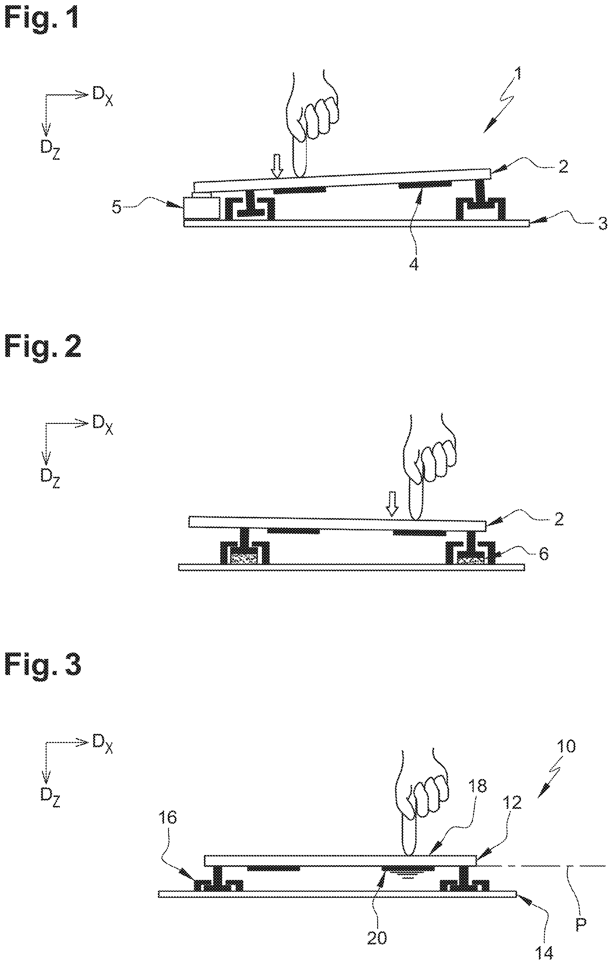

Dans le dispositif de commande représenté sur la figure 1, le dispositif de commande 1 comprend une dalle 2 montée de manière coulissante sur un châssis 3 de telle sorte qu'elle peut se déplacer en translation selon une direction Dx, sous l'impulsion d'un actionneur (non représenté), et selon une direction Dz, sous l'action d'une pression exercée par un utilisateur. Lorsqu'un utilisateur approche un de ses doigts d'une zone supérieure de la dalle 2 qui est positionnée à l'aplomb d'un capteur capacitif 4 fixé sous la dalle 2, il actionne le capteur capacitif 4 qui génère un signal pour alerter une unité de commande (non représentée) de l'intention de l'utilisateur d'activer une commande spécifiquement affectée à ladite zone. Par la suite, lorsque l'utilisateur approche plus près son doigt jusqu'à venir en appui avec ladite zone supérieure, il provoque un déplacement de la dalle 2 selon la direction Dz au niveau de la zone supérieure, ce qui enfonce un micro-switch 5 disposé sous la dalle 2. Ce micro-switch 5 génère en réaction un signal qui est envoyé à l'unité de commande, laquelle peut alors déclencher la commande et le retour haptique correspondant. L'inconvénient de ce type de dispositif de commande est l'orientation parfois oblique de la dalle 2 au moment de l'application du retour haptique, comme représenté sur la figure 1, qui ne permet pas d'avoir un guidage constant de la dalle 2 lors de sa translation selon la direction Dx, et, de ce fait, peut aboutir à une mauvaise perception du retour haptique par l'utilisateur. Dans certains cas également, il peut arriver que la position inclinée de la dalle 2 aboutisse à une absence de contact entre la dalle et le micro-switch, notamment lorsque l'utilisateur appuie sur une zone de la dalle 2 qui est éloignée du micro-switch. Il en résulte donc une non-détection de l'action et, par conséquent, une absence de retour haptique. De plus, le micro-switch ne permet pas de mesurer la force de l'effort qui est appliqué par l'utilisateur et donc de moduler le retour haptique en fonction de l'effort appliqué.

Le dispositif de commande représenté sur la figure 2 diffère de celui de la figure 1 par l'utilisation de jauges de contraintes 6 à la place de micro-switch. Même si cette configuration permet de résoudre en partie les problèmes mentionnés précédemment, il faut constater que la dalle 2 est encore positionnée de manière légèrement oblique lorsque le retour haptique est appliqué, ce qui gêne le guidage de la dalle 2 lors de sa translation selon la direction Dx : l'effet haptique peut donc ne pas être correctement perçu par l'utilisateur.

Les deux systèmes précités impliquent également que la dalle, en plus de permettre le mouvement de vibration du retour haptique (sens sensiblement perpendiculaire à l'action du doigt de l'utilisateur), soit également libre de déplacement dans le sens sensiblement parallèle à l'appui du doigt de l'utilisateur. Cette nécessité d'avoir au moins deux degrés de liberté va à l'encontre du respect des jeux et affleurements et donc d'une meilleure qualité d'aspect des pièces ainsi équipées de dispositif à retour haptique.

Un but de la présente invention est de proposer un dispositif de commande ne présentant pas les inconvénients cités précédemment.

A cet effet, l'invention concerne un dispositif de commande destiné à commander une fonction d'un véhicule automobile, le dispositif de commande comprenant :
- un dalle tactile comprenant une surface externe munie d'une ou plusieurs zones de commande affectées chacune à une fonction spécifique du véhicule automobile, la dalle tactile supportant un ou plusieurs capteurs élémentaires positionnés chacun à l'aplomb d'une desdites zones de commande, ledit ou lesdits capteurs élémentaires étant susceptibles de générer au moins un signal en réponse à une action exercée par l'utilisateur sur au moins l'une desdites zones de commande,
- au moins un actionneur configuré pour fournir à un utilisateur un retour haptique par déplacement en translation de la dalle tactile dans un plan, dit plan de vibration, et selon une seule direction de déplacement,
- une unité de contrôle configurée pour recevoir ledit au moins un signal généré par lesdits capteurs élémentaires et pour contrôler ledit au moins un actionneur en réponse audit signal,
dans lequel le dispositif de commande comporte des moyens de support et de guidage destinés à maintenir la dalle tactile alignée dans le plan de vibration et dans lequel chacun des capteurs élémentaires comprend au moins un substrat isolant sur lequel sont déposées des pistes conductrices formant un capteur capacitif et une assemblée de nanoparticules conductrices ou semi-conductrices en suspension colloïdale dans un ligand électriquement isolant, ladite assemblée formant un capteur de force.

Ainsi configuré, le dispositif de commande de l'invention permettra de générer un effet haptique qui soit correctement perceptible par l'utilisateur tout en assurant une meilleure qualité d'aspect des pièces équipées du dispositif de commande.

Selon d'autres caractéristiques, le dispositif de commande de l'invention pourra comporter une ou plusieurs des caractéristiques optionnelles suivantes considérées seules ou en combinaison ;
- au moins l'une des zones de commande forme une portion de la surface externe de la dalle tactile sur laquelle un doigt d'un utilisateur peut s'appuyer, ladite au moins une zone de commande étant disposée de manière contiguë à l'un des capteurs élémentaires de telle sorte que l'appui sur ladite au moins une zone de commande génère une déformation dudit capteur élémentaire qui peut être détectée par le capteur de force dudit capteur élémentaire.
- ledit au moins un actionneur comprend une partie fixe reliée à un châssis du dispositif et une partie mobile dans un entrefer de la partie fixe, la partie mobile étant reliée à la dalle tactile.
- la partie mobile dudit au moins un actionneur comprend un aimant ou un réseau d'aimants et la partie fixe dudit au moins un actionneur comprend une bobine ou un réseau de bobines.
- ledit au moins un actionneur comprend un moteur rotatif muni d'un arbre rotatif, l'arbre rotatif constituant la partie mobile dudit au moins un actionneur.
- ledit au moins un actionneur comprend un actionneur inertiel par translation.
- les moyens de support et de guidage comprennent plusieurs agrafes de fixation, chacune des agrafes de fixation étant solidaire d'un châssis du dispositif, et plusieurs pattes de fixation, chacune des pattes de fixation étant solidaire de la dalle tactile, les pattes de fixation étant configurées pour coopérer avec les agrafes de fixation pour permettre un clippage entre la dalle tactile et le châssis et pour empêcher le déplacement de la dalle tactile par rapport au châssis dans un direction perpendiculaire par rapport au plan de vibration tout en permettant un guidage de ladite dalle tactile lors de son déplacement en translation vis-à-vis du châssis selon la direction de déplacement.
- la patte de fixation présente une excroissance à son extrémité libre et chaque agrafe de fixation est munie de deux languettes élastiquement déformables dans le plan de vibration et selon une direction perpendiculaire à la direction de déplacement, lesdites languettes étant configurées pour former une ouverture de passage à travers laquelle peut s'insérer la patte de fixation, ladite ouverture de passage ne permettant pas, dans un état non déformé de l'agrafe de fixation, le passage de l'excroissance de la patte de fixation.
- l'unité de contrôle est configurée pour faire varier le retour haptique généré par ledit au moins un actionneur en fonction de l'intensité d'une pression exercée par l'utilisateur sur au moins l'une desdites zones de commande.

L'invention porte également sur un véhicule automobile comprenant un dispositif de commande tel que défini précédemment.

L'invention est exposée ci-après selon plusieurs modes de réalisation préférés, nullement limitatifs, et en référence aux figures 1 à 17 dans lesquelles :
La Figure 1 est une vue schématique d'un premier exemple de dispositif de commande selon l'art antérieur ;
La Figure 2 est une vue schématique d'un deuxième exemple de dispositif de commande selon l'art antérieur ;
La Figure 3 est une vue schématique d'un dispositif de commande selon l'invention
La Figure 4 est une vue en perspective d'un élément d'habitacle d'un véhicule automobile intégrant un dispositif de commande selon l'invention ;
La Figure 5 est une vue agrandie de l'élément d'habitacle représenté sur la figure 4, le dispositif de commande étant représenté dans sa position normale d'utilisation ;
La Figure 6 est une vue similaire à la figure 5, le dispositif de commande étant représenté dans un état démonté ;
La Figure 7 est une vue agrandie d'une partie supérieure du dispositif de commande représenté sur la figure 6;
La Figure 8 est une vue agrandie d'un élément de support et de guidage du dispositif de commande représenté sur la figure 7;
La Figure 9 est une vue en perspective éclatée d'un actionneur pouvant équiper le dispositif de commande selon l'invention ;
La Figure 10 est une vue de dessus, selon un premier mode de réalisation, d'un capteur élémentaire utilisable dans le dispositif de commande de l'invention ;
La Figure 11 est une vue en coupe selon la ligne de coupe AA du capteur de la figure 10 ;
La Figure 12 est une vue similaire à la figure 11 mais selon un deuxième mode de réalisation d'un capteur élémentaire utilisable dans le cadre de l'invention ;
La Figure 13A est une vue en coupe d'un capteur élémentaire selon un autre mode de réalisation lors d'une détection de proximité ;
La Figure 13B est une vue similaire à la figure 13A lors d'une détection d'un toucher ;
La Figure 13C représente l'évolution temporelle du signal issu du capteur de force formé par le capteur élémentaire des figures 13A et 13B ;
La Figure 13D représente l'évolution temporelle du signal issu du capteur capacitif formé par le capteur élémentaire des figures 13A et 13B ;
La Figure 14 représente selon une vue de dessus en éclaté un exemple de réalisation d'une surface tactile combinant une pluralité de capteurs élémentaires utilisables dans le cadre de l'invention ;
La Figure 15 montre l'organigramme d'un exemple de procédé mettant en oeuvre un capteur élémentaire utilisable dans le cadre de l'invention ;
La Figure 16 est un exemple d'organigramme d'un procédé mettant en oeuvre une surface tactile intégrant un capteur élémentaire utilisable dans le cadre de l'invention.
La Figure 17 montre la variation de la tension délivrée en fonction du temps par un capteur de force mettant en oeuvre une assemblée de nanoparticules dont la conductivité varie selon la force appliquée audit capteur.

Les dessins sont des représentations de principe et ne sont pas représentatifs de l'échelle des différents éléments qu'ils représentent.

### Description des modes de réalisation

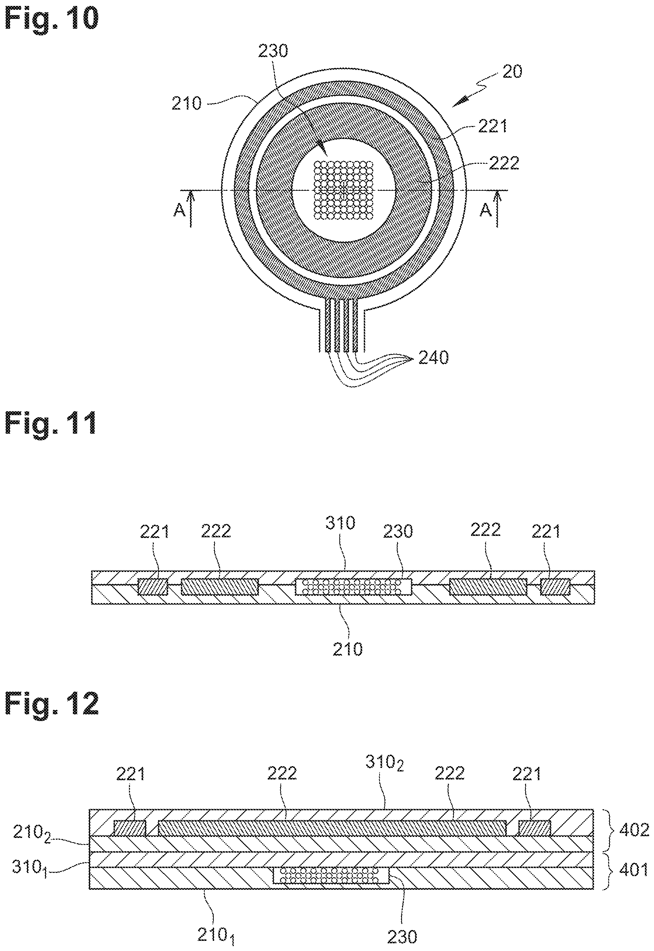

En référence à la figure 3, il est représenté un dispositif de commande 10 conforme à l'invention. Ce dispositif de commande 1 comprend une dalle 12 montée de manière coulissante sur un châssis 14 de telle sorte qu'elle peut se déplacer en translation selon une direction Dx (sensiblement perpendiculaire à l'action du doigt de l'utilisateur) sous l'impulsion d'un actionneur (non représenté), générant ainsi un effet haptique qui peut être perçu par un utilisateur qui touche la surface supérieure de la dalle 12 avec l'un de ses doigts. La direction Dx est parallèle à un plan P, dit plan de vibration. La dalle 12 repose sur des éléments de support 16 de telle manière qu'elle ne peut pas se déplacer par rapport au châssis 14 selon une direction Dz perpendiculaire au plan de vibration P. Ces éléments de support 16 sont par ailleurs configurés pour guider la dalle 12 lors de son déplacement le long de la direction Dx. Le fonctionnement du dispositif de commande 10 repose sur l'utilisation de capteurs élémentaires 20 bien spécifiques disposés sous la surface inférieure de la dalle 12 à l'aplomb de zones de commande 18 formées au niveau de la surface supérieure de la dalle 12. Ces capteurs élémentaires 20 seront susceptibles de générer au moins un signal en réponse à une action exercée par l'utilisateur sur au moins l'une desdites zones de commande, notamment une pression plus ou moins forte exercée par un utilisateur au moyen d'un de ses doigts sur l'une des zones de commande 18. Des exemples préférentiels de tels capteurs élémentaires sont notamment décrits dans les paragraphes suivants en lien avec les figures 10 à 17. Ces capteurs élémentaires préférentiels regroupent sur un même substrat des capteurs capacitifs et des capteurs de force. Ces capteurs élémentaires pourront ainsi détecter l'intention d'un utilisateur au moyen de leurs capteurs capacitifs et l'action de cet utilisateur au moyen de leurs capteurs de force. Les capteurs de force permettront notamment de mesurer la pression exercée par un utilisateur avec son doigt. Ainsi, lorsqu'un utilisateur approche un de ses doigts d'une zone de commande 18 de la dalle 12 qui est positionnée à l'aplomb d'un des capteurs élémentaires 20, il actionne le capteur capacitif de ce capteur élémentaire 20, lequel génère en réponse un signal pour alerter une unité de commande (non représentée) de l'intention de l'utilisateur d'activer une commande spécifiquement affectée à ladite zone de commande 18. Par la suite, lorsque l'utilisateur approche plus près son doigt jusqu'à venir en appui avec ladite zone de commande 18, il presse sur le capteur de force de ce capteur élémentaire 20. Cette pression est mesurée et un signal est généré en réponse et envoyé à l'unité de commande, laquelle peut alors déclencher la commande et le retour haptique correspondant. L'avantage de ces capteurs élémentaires 20 est qu'ils sont sensibles à la pression et ne nécessitent pas de déplacement de la dalle 12 selon la direction Dz. Ainsi, lors de l'application de l'effet haptique, la dalle 12 reste constamment alignée dans le plan de vibration P, comme représenté sur la figure 3. Cette position dans un même plan permet d'avoir un guidage amélioré de la dalle 12 lors de sa translation selon la direction Dx, et, de ce fait, procure une meilleure perception du retour haptique par l'utilisateur. D'autres capteurs pourront toutefois être utilisés en lieu et place des capteurs élémentaires préférentiels décrits précédemment. En particulier, une combinaison de capteurs capacitifs et de capteurs de pression utilisant la technologie FSR (« Force Sensing Resistor »), c'est-à-dire utilisant des résistances sensibles à la pression, pourra constituer une solution alternative envisageable.

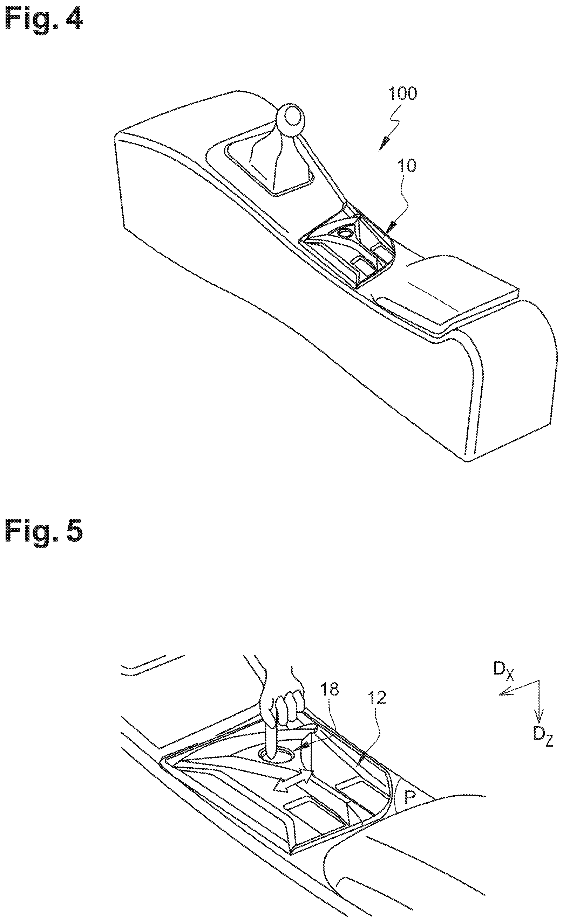

En référence aux figures 4 à 6, il est représenté un mode particulier de réalisation d'un dispositif de commande selon l'invention.

Dans ce mode de réalisation, le dispositif de commande 10 est intégré dans un élément d'habitacle 100 d'un véhicule automobile, cet élément d'habitacle 100 pouvant par exemple être une console centrale séparant les deux sièges avant du véhicule automobile. Ce dispositif de commande 10 est notamment constitué d'une dalle 12 sensiblement plate et de forme rectangulaire. La dalle 12 est fixée sur un châssis 14 au moyen de plusieurs agrafes de fixation 161 solidaires du châssis 14. Comme représenté sur la figure 5, ces agrafes de fixation 161 sont configurées pour maintenir la dalle 12 fixe par rapport au châssis 14 dans une direction Dz perpendiculaire à un plan P défini par la dalle, tout en permettant une translation de ladite dalle 12 dans une direction Dx parallèle au plan P. Cette translation pourra s'opérer sous l'action d'un actionneur 30 disposé entre le châssis 14 et la dalle 12.

La surface supérieure de la dalle 12 est munie d'un bouton de commande 18 de forme circulaire. Lorsque l'utilisateur appuie sur ledit bouton de commande 18, il actionne un capteur (non visible sur les figures 4 à 6) disposé à l'aplomb du bouton de commande 18. Cet actionnement provoque l'envoi d'un signal à une unité de commande (non représentée) qui, en fonction du signal reçu, commande l'actionneur 30 de manière à provoquer un déplacement relatif plus ou moins important d'une partie mobile de cet actionneur 30, qui est reliée fixement à la dalle 12, par rapport à une partie fixe de l'actionneur 30, qui est reliée fixement au châssis 14. Il en résulte un déplacement relatif de la dalle 12 par rapport au châssis 14 sous l'action de l'actionneur 30, ce qui génère un effet haptique dans la dalle 12.

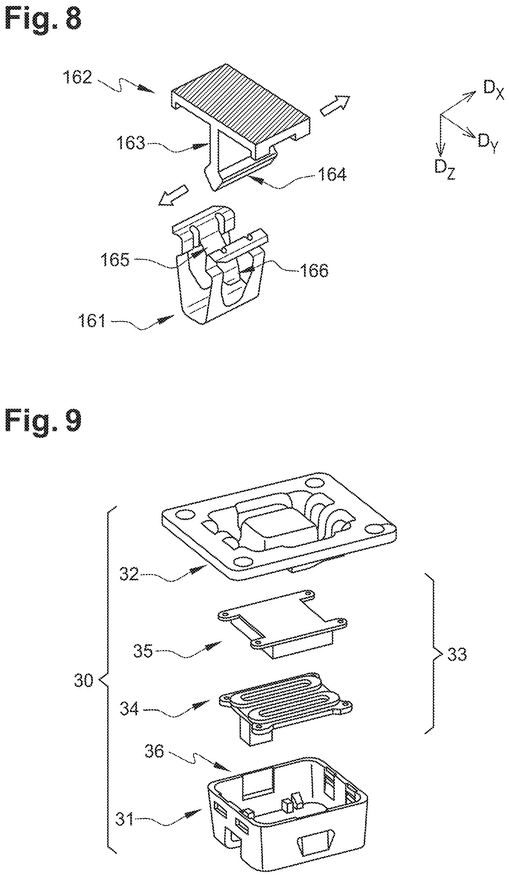

Un exemple d'actionneur 30 utilisable dans le cadre de l'invention est notamment représenté sur la figure 9. Cet actionneur 30 comprend notamment un conteneur 31 creux de forme parallélépipédique, ledit conteneur 31 délimitant un logement 36 destiné à contenir un réseau de bobines 34 et un réseau d'aimants 35, et un couvercle 32 configuré pour obturer une ouverture supérieure dudit conteneur 31. Le réseau de bobines est fixé sur une face interne du conteneur 31 et le réseau d'aimants est fixé sur une face interne du couvercle 32 faisant face au logement 36. Le couvercle 32 et le conteneur 31 sont fixés l'un à l'autre de sorte à permettre un déplacement en translation relative du couvercle 32 vis-à-vis du conteneur 31 selon une direction de déplacement Dx. Ainsi, lors du fonctionnement de l'actionneur 30, le réseau de bobines 34 est alimenté en courant électrique et génère un champ magnétique qui se traduit par un mouvement de translation du réseau d'aimants 35. Le réseau d'aimants 35 étant fixé au couvercle 32, ce dernier se déplace également selon la direction Dx par rapport au conteneur 31. En fixant respectivement le couvercle 32 sur la dalle 12 et le conteneur 31 sur le châssis 14, il est ainsi possible de générer un mouvement relatif selon la direction Dx de la dalle 12 vis-à-vis du châssis 14 au moyen de l'actionneur 30. Ce déplacement relatif permet de générer des vibrations haptiques dans la dalle 12.

Une autre variante possible de l'actionneur 30 pourrait consister en un moteur rotatif muni d'un arbre rotatif, l'arbre rotatif constituant la partie mobile de l'actionneur et le moteur rotatif étant solidaire de la partie fixe de l'actionneur. Ce type d'actionneur est un actionneur inertiel, la partie tournante n'est pas reliée à la dalle mais génère la vibration par une masselotte mise en rotation.

Une autre variante possible de l'actionneur 3D pourrait consister en une masselotte inertielle mise en vibration par translation dans une bobine.

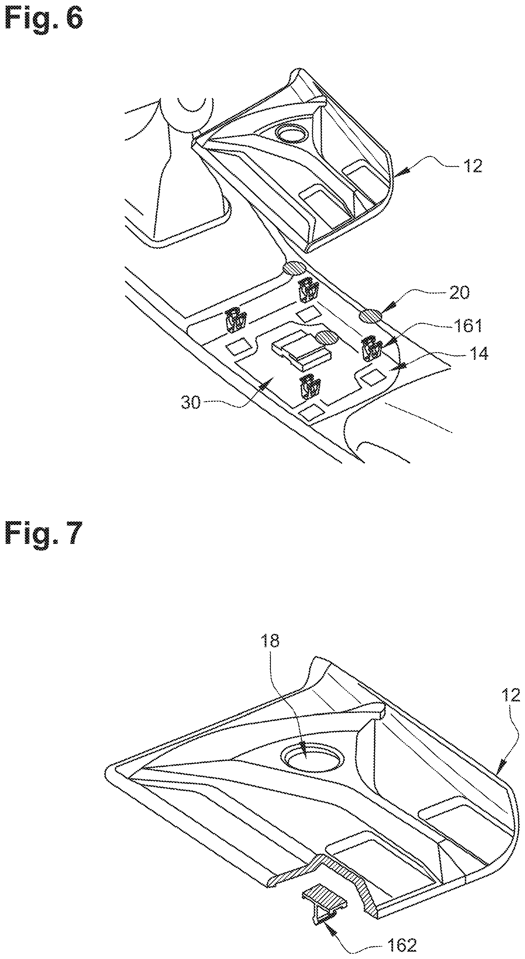

En référence aux figures 7 et 8, il est représenté en détail les éléments complémentaires permettant la fixation coulissante de la dalle 12 sur le châssis 14. Le premier élément est constitué par les agrafes de fixation 161 mentionnées précédemment et le deuxième élément est constitué par des pattes de fixation 162 s'étendant perpendiculairement de la surface inférieure de la dalle 12. Ces pattes de fixation 162 pourront être venues de matière avec la dalle 12 ou fixées sur cette dernière par tout moyen de fixation envisageable. Les pattes de fixation 162 sont configurées pour venir s'emboîter à l'intérieur des agrafes de fixation 161 de manière à assurer une fixation coulissante de la dalle 12 sur le châssis 14, la dalle 12 pouvant uniquement coulisser le long de la direction Dx une fois fixée sur le châssis 14. A cet effet, chacune des pattes de fixation 162 est constituée d'une section droite 163 munie d'une excroissance 164 à son extrémité libre et chaque agrafe de fixation 161 est munie de deux languettes 165 élastiquement déformables dans le plan de vibration P et selon une direction Dy perpendiculaire à la direction Dx. Dans l'état non monté représenté sur la figure 8, les languettes 165, 166 forment une ouverture de passage dont la largeur selon la direction Dy est suffisante pour permettre l'insertion de la section droite 163 de la patte de fixation 162, mais insuffisante pour permettre le passage de l'excroissance 164. Lors de l'opération de montage, la dalle 12 est d'abord disposée de manière à aligner la section droite 163 de chaque patte de fixation 162 avec une ouverture de passage de l'une des agrafes de fixation 161 et la dalle est ensuite déplacée en direction du châssis 14 parallèlement à la direction Dz jusqu'à ce que l'excroissance 164 vienne buter contre les languettes 165, 166. En appuyant suffisamment sur la dalle 12, il est possible de déformer l'agrafe de fixation 161 de manière à élargir l'ouverture de passage, permettant ainsi le passage de l'excroissance 164 à travers l'ouverture de passage. L'excroissance 164 vient ensuite se positionner sous les languettes 165, lesquelles reprennent leur état non déformé représenté sur la figure 8. Un déplacement inverse de la patte de fixation 161 selon la direction Dz est alors empêché, notamment par la présence de rebords 166 à l'extrémité des languettes 165, qui, en étant orientés perpendiculairement à la direction Dz, constituent des zones de butées pour l'excroissance 164. L'association des agrafes de fixation 161 et des pattes de fixation 162 permet donc une fixation par clippage de la dalle 12 sur le châssis 14. Ces moyens de fixation complémentaires empêchent, comme décrit précédemment, le déplacement de la dalle 12 par rapport au châssis 14 dans la direction Dz. Par ailleurs, du fait de la possibilité pour la section droite 163 de chaque patte de fixation 162 de coulisser le long de la direction Dx à travers l'ouverture de passage définie par les languettes 165, tout en étant maintenue en position par l'appui élastique exercé par les languettes 165, ces moyens de fixation complémentaires permettent de guider la dalle 12 lors de son déplacement vis-à-vis du châssis 14 selon la direction Dx sous l'action de l'actionneur 30.

La figure 10 représente un exemple de réalisation d'un capteur élémentaire 20 utilisable dans le boîtier de commande de l'invention. Ce capteur élémentaire 20 comprend un substrat isolant 210 sur lequel sont déposées, par des techniques connues de l'art antérieur, des pistes conductrices concentriques 221, 222 constituant un capteur capacitif.

Le substrat isolant 210 est, selon des exemples de réalisation, un polymère, par exemple un polyimide ou un PET, ou une céramique.

Lesdites pistes concentriques 221, 222 sont par exemple constituées de cuivre, d'ITO (In₂O₃ - SnO₂) pour réaliser un capteur transparent ou de tout autre matériau conducteur.

Elles sont déposées, par exemple, par photolithographie ou par lithographie douce.

Au centre du capteur est déposée une assemblée de nanoparticules constituant un capteur de force.

Selon un exemple de réalisation, adapté à la réalisation d'un capteur transparent, lesdites nanoparticules sont des nanoparticules d'ITO en suspension colloïdale dans un ligand isolant, par exemple un acide (aminométhyl) phosphonique (CH₆NO₃P).

Selon d'autres exemples de réalisation les nanoparticules sont des nanoparticules d'oxyde de zinc (ZnO) ou des nanoparticules d'or (Au).

L'assemblée de nanoparticules 230 est une assemblée monocouche ou multicouche, déposée sur le substrat, par exemple, par dépôt capillaire convectif ou par une méthode dite « d'évaporation de goutte » telle que décrite dans le document EP 2 877 911, sans que ces exemples ne soient exhaustifs ni limitatifs.

L'assemblée de nanoparticules 230 est fermement liée au substrat 210, par exemple par l'intermédiaire d'un coupleur chimique.

À titre d'exemple, le coupleur chimique est un silane (SiH4), apte à interagir avec des groupements OH de la surface du substrat préalablement activée par un traitement UV-Ozone et comportant à l'autre extrémité du coupleur un groupement carboxylique (COOH) apte à se greffer sur un groupe amine (NH2) préalablement greffé à la surface des nanoparticules.

L'assemblée de nanoparticules 230 constitue une jauge de déformation, dont la conductivité électrique varie en fonction de la distance relative entre les nanoparticules de l'assemblée.

Cette variation de conductivité ou réciproquement de résistance électrique est attribuée à la conduction par effet tunnel entre les nanoparticules, et cet effet fournit un facteur de jauge très élevé, beaucoup plus élevé que ce qu'il est possible d'obtenir avec un film piézorésistif, ce qui permet de mesurer de très faibles déformations.

À titre d'exemple, la variation proportionnelle de la résistance d'un tel capteur de force élémentaire, constitué d'une assemblée de nanoparticules d'ITO dans un ligand à base d'acide phosphonique, fait apparaître une évolution exponentielle de la réponse en fonction de la déformation subie par ledit capteur élémentaire, avec un facteur de jauge atteignant la valeur de 85 sur une plage de déformation de -1 %, en compression, à +1 % en traction pour une résistance de l'ordre de 2000.10³ Ohm en l'absence de déformation.

Ainsi ce capteur de force élémentaire est très sensible et permet de détecter une force d'appui ou de toucher, même relativement faible, appliquée audit capteur, qui peut ainsi constituer son propre corps d'épreuve. En d'autres termes, la déformation du substrat n'est pas nécessaire pour détecter un effort appliqué et l'agencement représenté sur la figure 10 est réalisable sur un substrat rigide tel que du dioxyde de silicium (SiO₂) ou de nitrure de silicium (Si₃N₄) tout en permettant une mesure de la force appliquée au capteur.

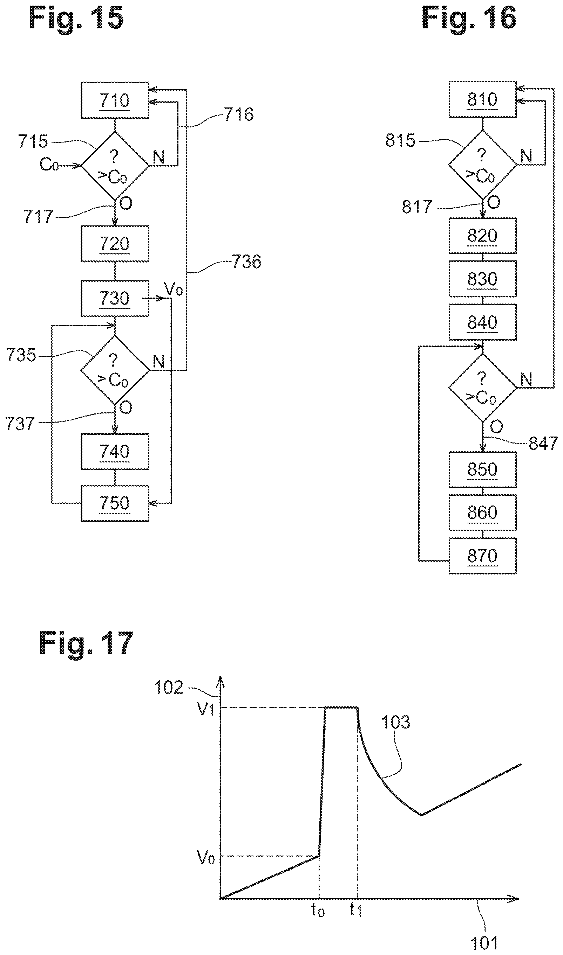

En référence à la figure 17, il est représenté un exemple de variation de la tension 102 délivrée en fonction du temps 101 par un tel capteur de force élémentaire lors de l'application d'une force sur ledit capteur, par exemple un toucher. Selon cet exemple, le toucher est appliqué entre les temps t₀ et t₁. L'intensité de la force est proportionnelle à la différence V₁-V₀, dans laquelle la valeur V₁ est mesurable et la valeur V₀ dépend de facteurs environnementaux et est susceptible de varier dans le temps, notamment avec la température.

Des pistes conductrices 240, représentées ici selon une représentation de principe, également déposées sur le substrat 210, permettent l'alimentation électrique et la collecte des données du capteur capacitif et du capteur de force.

Selon un premier mode de réalisation représenté sur la figure 11, une couche protectrice 310 est constituée d'un matériau isolant, par exemple un polyimide, ou un PET pour la réalisation d'un capteur transparent, est déposée sur le capteur ainsi créé.

Selon ce premier mode de réalisation, le capteur élémentaire combiné a un diamètre compris entre 10 mm et 30 mm et une épaisseur comprise entre 50 µm et 300 µm sans que ces valeurs ne soient limitatives.

Selon un deuxième mode de réalisation représenté sur la figure 12, le capteur élémentaire combiné est réalisé en 2 couches 401, 402, la première couche 401 comprenant, selon ce deuxième mode de réalisation, un substrat 201₁ sur lequel est déposé le capteur de force 230 selon une technologie identique à ce qui a été exposé ci-avant, et une couche 310₁ de protection, et superposée à cette première couche 401, une seconde couche 402 comprenant un substrat 210₂ sur lequel sont déposés les pistes conductrices 221, 222 réalisant le capteur capacitif.

Une couche de protection 310₂ est posée sur ledit capteur capacitif.

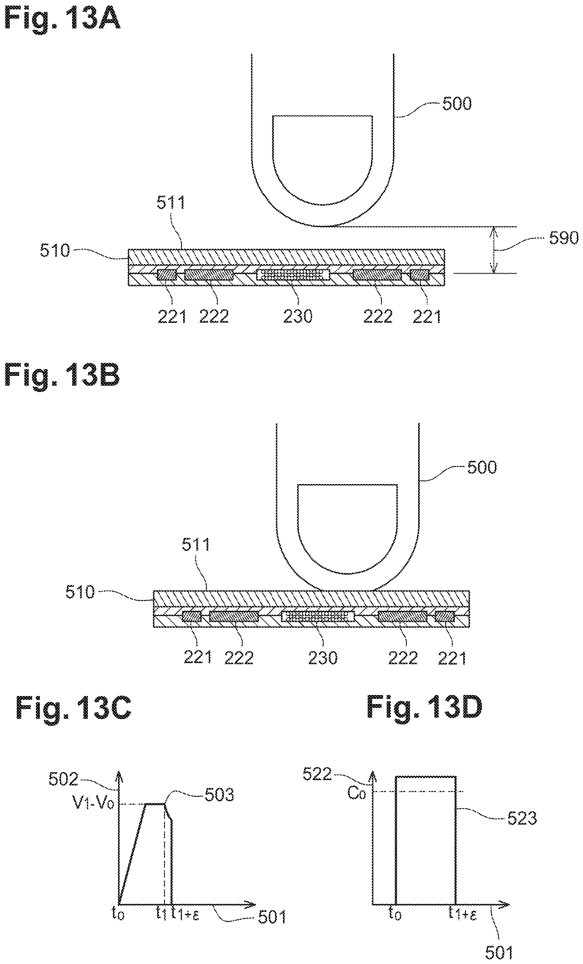

Selon un exemple de mise en oeuvre représenté sur les figures 13A et 13B, le capteur élémentaire est rapporté sur une face d'un substrat 510 isolant, la face opposée 511 dudit substrat étant exposée au toucher.

Ainsi, la surface 511 de ce substrat 510 est fonctionnalisée et permet de détecter un toucher sur cette surface et de mesurer la force d'application de ce toucher.

Selon des exemples de réalisation non limitatifs, ledit substrat 510 pourra être constitué d'un polymère, de verre, de céramique, de cuir ou de bois. La sensibilité du capteur de force permet de détecter une faible déformation, et ainsi de détecter et mesurer une force de toucher même si ce substrat est relativement rigide.

Comme illustré sur la figure 13A, lorsqu'un objet électriquement conducteur, par exemple un doigt 500, est approché de la surface 511 ainsi fonctionnalisée, à un temps t₀, sa présence est détectée, avant même qu'il n'y ait contact, dès lors que celui-ci se trouve à une distance inférieure ou égale à une distance minimale 590 du capteur capacitif.

Cette distance minimale 590 est ajustable selon les caractéristiques du capteur et un seuil défini sur le signal délivré par ledit capteur capacitif.

A titre d'exemple, la distance minimale est sélectionnée pour toute valeur entre 0 et 10 mm selon l'application visée.

A cette fin, le capteur est connecté à un circuit électronique apte à réaliser ces fonctions ainsi que les étapes du procédé exposé ci-après.

Ainsi, au temps t₀, comme le montre la figure 13D, en observant la valeur du signal 522 délivré par le capteur capacitif en fonction du temps 501, l'information 523 délivrée par ledit capteur franchit un seuil C₀ correspondant au franchissement de la distance minimale 590. Puis, dès lors que l'objet 500 entre en contact avec la surface, l'information délivrée par le capteur capacitif n'évolue plus ou très peu, même si la pression appliquée augmente.

En revenant à la figure 17, lorsque la proximité de l'objet 500 est détectée, la valeur V₀ délivrée par le capteur de force au temps t₀ est mesurée et prise pour valeur de référence, en faisant correspondre à cette valeur une force égale à 0, puisqu'il n'y a pas contact, comme le montre la figure 13C, qui représente la valeur 502 du signal 503 délivré par le capteur de force en fonction du temps 501, modifiée par le traitement.

Ainsi, tout phénomène de dérive de l'information délivrée par le capteur de force, notamment du fait de variations de température, est compensé.

Comme le montre la figure 13B, lorsque l'objet 500 entre en contact avec la surface fonctionnalisée 511 et applique une force de toucher sur celle-ci, la conductivité du capteur de force est modifiée proportionnellement à la force appliquée, et celui-ci délivre, comme illustré sur la figure 13C, une information V₁ correspondant à une force proportionnelle à V₁-V₀ , corrigée de la valeur de dérive initiale V₀ du capteur de force 230.

Lorsque la pression de toucher est relâchée au temps t₁, à bref instant (t₁+e) suivant ce relâchement, l'objet 500 se trouve à une distance de la surface 511, supérieure ou égale à la distance minimale 590, et, comme illustrée sur la figure 13D, l'information délivrée par le capteur capacitif franchit le seuil C₀ en sens inverse.

Lorsque le franchissement de ce seuil C₀ est détecté sur le capteur capacitif, l'information délivrée par le capteur de force est considérée égale à 0. Ainsi, le retour différé à 0 de l'information délivrée par le capteur de force, du fait des phénomènes d'hystérésis, est également masqué.

Ainsi, l'utilisation combinée du capteur de force et du capteur capacitif permet de mesurer une force appliquée, et le cas échéant de déclencher des actions en fonction du niveau de cette force, en s'affranchissant des phénomènes de dérive et d'hystérésis inhérents à ce type de capteur de force et tels que représentés sur la figure 17.

Les figures 13A et 13B représentent un capteur combiné selon le premier mode de réalisation représenté sur la figure 11, l'homme du métier comprend que les mêmes principes sont applicables dans le cas d'un capteur combiné correspondant au deuxième mode de réalisation représenté sur la figure 12.

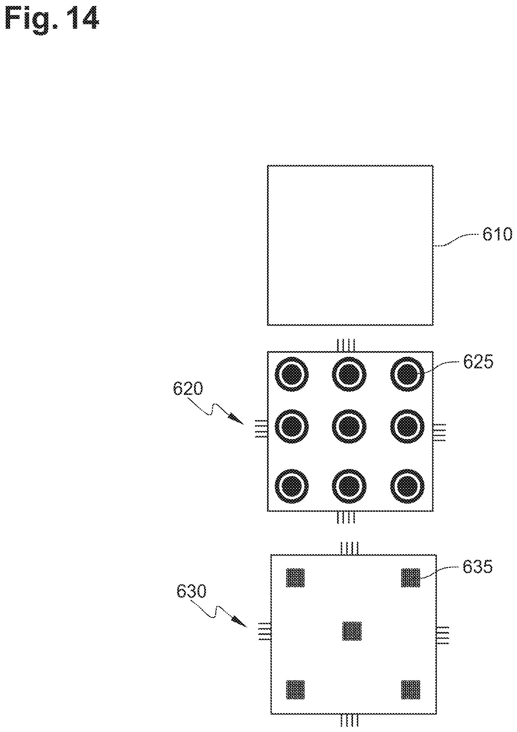

En référence à la figure 14, une pluralité de capteurs élémentaires sont associés en grille de sorte à former une surface tactile apte à détecter un toucher, sa localisation sur la grille et l'effort de pression exercé.

La figure 14 représente un mode de réalisation combinant une pluralité de capteurs selon le mode de réalisation représenté sur la figure 12. L'homme du métier pourra adapter ce principe au mode de réalisation du capteur élémentaire représenté sur la figure 11.

Ladite surface tactile comprend un substrat 610, constitué d'une matière électriquement isolante, et comportant une surface exposée au toucher.

Sur la face opposée à cette surface exposée au toucher du substrat 610 est rapportée une première couche 620 comprenant une grille de capteurs capacitifs 625, tels que la couche supérieure 402 de la figure 12.

Sous la couche 620 portant la grille de capteurs capacitifs est rapportée une couche 630 comprenant une grille de capteurs de force 635 constitués d'assemblées de nanoparticules, tels que la couche inférieure 401 de la figure 12.

Selon un premier exemple de réalisation (non représenté), le nombre de capteurs de force 635 est égal au nombre de capteurs capacitifs 625 et lesdits capteurs de force sont localisés centrés par rapport aux capteurs capacitifs.

Avantageusement, le nombre de capteurs de force 635 est réduit par rapport au nombre de capteurs capacitifs 625 et lesdits capteurs de forces sont localisés centrés, ou non, par rapport auxdits capteurs capacitifs.

Ce mode de réalisation, utilisant un nombre de capteurs de force réduit est plus économique.

En effet, quel que soit le point d'application de la force de toucher sur la surface tactile ainsi créée, l'effort de toucher est évalué, connaissant ce point d'application, et déduit des signaux délivrés par un des capteurs de force, par exemple celui le plus proche du point d'application, ou par la combinaison des informations délivrées par plusieurs de ces capteurs, au minimum 3 capteurs de force pour une surface tactile plane, selon des variantes de mise en oeuvre.

La localisation du point d'application du toucher sur la surface tactile est obtenue à partir de la grille de capteurs capacitifs 625.

Ce principe reste valable en cas de points de toucher multiples.

Ce mode de réalisation permet de réaliser une surface tactile comprenant une densité élevée de capteurs capacitifs, de réalisation plus économique que les capteurs de force, et ainsi d'obtenir une localisation précise du ou des points d'application du toucher, puis d'évaluer la force appliquée lors de ces touchers par un traitement approprié des informations délivrées par un nombre réduit de capteurs de force 635 de réalisation plus coûteuse, en fonction de localisation du ou des points d'application du toucher.

Le procédé mis en oeuvre reste similaire, à savoir que dès que la proximité d'un objet conducteur est détecté à une distance inférieure ou égale à la distance minimale 590 d'un des capteurs capacitifs, la valeur V₀ délivré par chacun des capteurs de force est mesurée de sorte à recaler l'information délivrée par chacun desdits capteur, l'effort d'application est déterminé en combinant les informations issues desdits capteurs de force en fonction de la localisation du point d'application de l'effort donné par le réseau de capteurs capacitifs, puis, lorsque l'objet s'éloigne de la surface tactile d'une distance supérieure ou égale à la distance minimale, l'effort est remis à 0.

L'homme du métier comprend que l'utilisation d'un nombre réduit de capteurs de force par rapport au nombre de capteurs capacitifs est applicable à une surface tactile de forme autre que plane, par exemple une surface en simple ou double courbure, dès lors que cette forme est stable.

Pour une surface tactile souple et de forme variable, par exemple une surface tactile appliquée sur un vêtement, le mode de réalisation comprenant un nombre de capteurs de force équivalent à celui des capteurs capacitifs et centrés par rapport à ceux-ci est préférable.

Ainsi, le dispositif tel que décrit précédemment offre dans ses variantes de réalisation des possibilités d'application très variées.

Comme illustré sur la figure 15, la mise en oeuvre d'un procédé pour la détection et la mesure de l'intensité d'une force de toucher par un objet 500 électriquement conducteur sur une surface tactile comprenant un capteur élémentaire tel que décrit ci-dessus, quel que soit son mode de réalisation, comprend, selon une fréquence ou par intervalle de temps définis, la lecture 710 du signal issu du capteur capacitif et la comparaison 715 de la valeur du signal ainsi lue à une valeur définie C₀ représentative d'une distance minimale entre un objet et le capteur capacitif.

Selon cet exemple de réalisation, et en référence aux figures 13A et 13D, lorsque cette distance est inférieure ou égale à une distance minimale, le signal délivré par le capteur capacitif est supérieur ou égal à une valeur C₀.

Dans le cas 716 où le signal délivré par le capteur capacitif reste inférieur à C₀, aucune autre action n'est déclenchée et la scrutation du signal à la fréquence ou par intervalle de temps donnés continue.

Dans le cas 717 où le signal délivré par le capteur capacitif franchit le seuil C₀ et donc qu'un objet se trouve à proximité dudit capteur, au cours d'étapes d'initialisation du capteur de force, la valeur délivrée par le capteur de force est lue 720 et au cours d'une étape de détermination de la dérive 730 la valeur ainsi lue V₀ est utilisée comme valeur de référence.

La mesure de l'effort appliqué est réalisée en regard de cette référence tant que l'objet est en contact avec la surface tactile. A cette fin le signal de sortie du capteur capacitif est comparé 735 à la valeur C₀ correspondant à la distance minimale, et tant que 737 la valeur délivrée par ce capteur reste supérieure à la valeur C₀, le signal issu du capteur de force est mesuré 740 et, au cours d'une étape recalage 750, recalé par rapport à la valeur V₀ déterminée lors de l'étape de détermination de la dérive 730 réalisée dans la même séquence d'acquisition.

Le procédé décrit à la figure 15 dans le cas d'un capteur élémentaire, s'étend au cas d'une surface tactile comprenant autant de capteurs élémentaires, avec des étapes supplémentaires consistant à localiser sur la grille de capteurs capacitifs celui où est détectée la proximité, et en fonction de cette information, appliquer les étapes de lecture de l'information délivrée 720 de mesure de dérive 730, de mesure de la force appliquée 740 et de recalage 750 au capteur de force le plus proche du capteur capacitif pour lequel la proximité du toucher est détectée.

Comme illustré sur la figure 16, dans le cas où la surface tactile comprend une densité nettement plus importante de capteurs capacitifs comparativement au nombre de capteurs de force, au cours d'une étape 810 de scrutation, les informations délivrées par les capteurs capacitifs sont sondées à intervalle de temps régulier et l'information délivrée par chaque capteur est comparée 815 à celle, C₀, correspondant au seuil de distance minimale.

Lorsque ce seuil est dépassé 817 sur l'un des capteurs, au cours d'une étape 820 de localisation, la position du capteur capacitif activé est déterminée.

Au cours d'une étape de détermination de dérive 830 l'information délivrée par chacun des capteurs de force est lue et cette information est assignée 840 à chacun des capteurs de force respectifs comme valeur de recalage.

Tout au long du toucher 847, l'information issue des capteurs de force est acquise 850, recalée 860 pour chaque capteur par la valeur évaluée lors de l'étape 830 de détermination de dérive.

Puis, en fonction du point d'application de l'effort, déterminé lors de l'étape de localisation 820, l'effort appliqué au point considéré est estimé 870 en combinant les informations issues des capteurs de forces.

## Revendications

1. Dispositif de commande (10) destiné à commander une fonction d'un véhicule automobile, le dispositif de commande (10) comprenant :
- un dalle tactile (12) comprenant une surface externe munie d'une ou plusieurs zones de commande (18) affectées chacune à une fonction spécifique du véhicule automobile, la dalle tactile (12) supportant un ou plusieurs capteurs élémentaires (20) positionnés chacun à l'aplomb d'une desdites zones de commande (18), ledit ou lesdits capteurs élémentaires (20) étant susceptibles de générer au moins un signal en réponse à une action exercée par l'utilisateur sur au moins l'une desdites zones de commande (18),
- au moins un actionneur (30) configuré pour fournir à un utilisateur un retour haptique par déplacement en translation de la dalle tactile (12) dans un plan (P), dit plan de vibration, et selon une seule direction de déplacement (Dx),
- une unité de contrôle configurée pour recevoir ledit au moins un signal généré par ledit ou lesdits capteurs élémentaires (20) et pour contrôler ledit au moins un actionneur (30) en réponse audit signal,
ledit dispositif de commande (10) comportant des moyens de support et de guidage (16) destinés à maintenir la dalle tactile (12) alignée dans le plan de vibration (P)
et étant **caractérisé en ce que** chacun des capteurs élémentaires (20) comprend au moins un substrat isolant (210) sur lequel sont déposées des pistes conductrices (221, 222) formant au moins un capteur capacitif et une assemblée (230) de nanoparticules conductrices ou semi-conductrices en suspension colloïdale dans un ligand électriquement isolant, ladite assemblée (230) formant au moins un capteur de force.

2. Dispositif de commande (10) selon la revendication 1, **caractérisé en ce qu'**au moins l'une des zones de commande (18) forme une portion de la surface externe de la dalle tactile (12) sur laquelle un doigt d'un utilisateur peut s'appuyer, ladite au moins une zone de commande (18) étant disposée de manière contiguë à l'un des capteurs élémentaires (20) de telle sorte que l'appui sur ladite au moins une zone de commande (18) génère une déformation dudit capteur élémentaire (20) qui peut être détectée par le capteur de force dudit capteur élémentaire (20).

3. Dispositif de commande (10) selon l'une des revendications précédentes, **caractérisé en ce que** ledit au moins un actionneur (30) comprend une partie fixe (31, 34) reliée à un châssis (14) du dispositif (10) et une partie mobile (32, 35) dans un entrefer de la partie fixe (31, 34), la partie mobile (32, 35) étant reliée à la dalle tactile (12).

4. Dispositif de commande (10) selon la revendication 3, **caractérisé en ce que** la partie mobile dudit au moins un actionneur (30) comprend un aimant ou un réseau d'aimants (35) et la partie fixe dudit au moins un actionneur (30) comprend une bobine ou un réseau de bobines (34).

5. Dispositif de commande (10) selon la revendication 3, **caractérisé en ce que** ledit au moins un actionneur (30) comprend un moteur rotatif muni d'un arbre rotatif, l'arbre rotatif constituant la partie mobile dudit au moins un actionneur.

6. Dispositif de commande (10) selon la revendication 3, **caractérisé en ce que** ledit au moins un actionneur (30) comprend un actionneur inertiel par translation.

7. Dispositif de commande (10) selon l'une des revendications précédentes, **caractérisé en ce que** les moyens de support et de guidage (16) comprennent plusieurs agrafes de fixation (161), chacune des agrafes de fixation (161) étant solidaire d'un châssis (14) du dispositif (10), et plusieurs pattes de fixation (162), chacune des pattes de fixation (162) étant solidaire de la dalle tactile (12), les pattes de fixation (162) étant configurées pour coopérer avec les agrafes de fixation (161) pour permettre un clippage de la dalle tactile (12) sur le châssis (14) et pour empêcher le déplacement de la dalle tactile (12) par rapport au châssis (14) dans une direction (Dz) perpendiculaire par rapport au plan de vibration (P) tout en assurant un guidage de ladite dalle tactile (12) lors de son déplacement en translation vis-à-vis du châssis (14) selon la direction de déplacement (Dx).

8. Dispositif de commande (10) selon la revendication 7, **caractérisé en ce que** la patte de fixation (162) présente une excroissance (164) à son extrémité libre et **en ce que** chaque agrafe de fixation (161) est munie de deux languettes (165) élastiquement déformables dans le plan de vibration (P) et selon une direction (Dy) perpendiculaire à la direction de déplacement (Dx), lesdites languettes (165) étant configurées pour former une ouverture de passage à travers laquelle peut s'insérer la patte de fixation (162), ladite ouverture de passage ne permettant pas, dans un état non déformé de l'agrafe de fixation (161), le passage de l'excroissance (164) de la patte de fixation (162).

9. Dispositif de commande (10) selon l'une des revendications précédentes, **caractérisé en ce que** l'unité de contrôle est configurée pour faire varier le retour haptique généré par ledit au moins un actionneur (30) en fonction de l'intensité d'une pression exercée par l'utilisateur sur au moins l'une desdites zones de commande (18).

10. Véhicule automobile comprenant un dispositif de commande (10) selon l'une des revendications précédentes.

## Patentansprüche

1. Steuervorrichtung (10), die dazu bestimmt ist, eine Funktion eines Kraftfahrzeugs zu steuern, wobei die Steuervorrichtung (10) Folgendes umfasst:
- einen Touchscreen (12), der eine Außenfläche umfasst, die mit einer oder mehreren Steuerzonen (18) versehen ist, die jeweils einer bestimmten Funktion des Kraftfahrzeugs zugeordnet ist, wobei der Touchscreen (12) einen oder mehrere Grundsensoren (20) unterstützt, die jeweils über einer der Steuerzonen (18) positioniert sind, wobei der oder die Grundsensoren (20) dazu geeignet sind, als Reaktion auf eine von dem Benutzer auf mindestens eine der Steuerzonen (18) ausgeübte Aktion mindestens ein Signal zu erzeugen,
- mindestens einen Aktor (30), der dazu konfiguriert ist, einem Benutzer durch translatorische Verschiebung des Touchscreens (12) in einer Ebene (P), die als Vibrationsebene bezeichnet wird, und in einer einzigen Verschiebungsrichtung (Dx) eine haptische Rückmeldung bereitzustellen,
- eine Steuereinheit, die dazu konfiguriert ist, das mindestens eine von dem oder den Grundsensoren (20) erzeugte Signal zu empfangen und den mindestens einen Aktor (30) als Reaktion auf das Signal zu steuern,
wobei die Steuervorrichtung (10) Stütz- und Führungsmittel (16) enthält, die dazu bestimmt sind, den Touchscreen (12) in Ausrichtung in der Vibrationsebene (P) zu halten, und **dadurch gekennzeichnet ist, dass** jeder der Grundsensoren (20) mindestens ein isolierendes Substrat (210), auf dem leitende Bahnen (221, 222) abgeschieden sind, die mindestens einen kapazitiven Sensor bilden, und eine Anordnung (230) aus leitenden oder halbleitenden Nanopartikeln in kolloidaler Suspension in einem elektrisch isolierenden Liganden umfasst, wobei die Anordnung (230) mindestens einen Kraftsensor bildet.

2. Steuervorrichtung (10) nach Anspruch 1, **dadurch gekennzeichnet, dass** mindestens eine der Steuerzonen (18) einen Abschnitt der Außenfläche des Touchscreens (12) bildet, auf den ein Benutzer mit einem Finger drücken kann, wobei die mindestens eine Steuerzone (18) derart angrenzend an einen der Grundsensoren (20) angeordnet ist, dass ein Druck auf die mindestens eine Steuerzone (18) eine Verformung des Grundsensors (20) erzeugt, die vom Kraftsensor des Grundsensors (20) erfasst werden kann.

3. Steuervorrichtung (10) nach einem der vorhergehenden Ansprüche, **dadurch gekennzeichnet, dass** der mindestens eine Aktor (30) einen festen Teil (31, 34), der mit einem Rahmen (14) der Vorrichtung (10) verbunden ist, und einen beweglichen Teil (32, 35) in einem Spalt des festen Teils (31, 34) umfasst, wobei der bewegliche Teil (32, 35) mit dem Touchscreen (12) verbunden ist.

4. Steuervorrichtung (10) nach Anspruch 3, **dadurch gekennzeichnet, dass** der bewegliche Teil des mindestens einen Aktors (30) einen Magneten oder eine Anordnung von Magneten (35) umfasst und der feste Teil des mindestens einen Aktors (30) eine Spule oder eine Anordnung von Spulen (34) umfasst.

5. Steuervorrichtung (10) nach Anspruch 3, **dadurch gekennzeichnet, dass** der mindestens eine Aktor (30) einen Drehmotor umfasst, der mit einer Drehwelle versehen ist, wobei die Drehwelle den beweglichen Teil des mindestens einen Aktors darstellt.

6. Steuervorrichtung (10) nach Anspruch 3, **dadurch gekennzeichnet, dass** der mindestens eine Aktor (30) einen Trägheitsaktor durch Translation umfasst.

7. Steuervorrichtung (10) nach einem der vorhergehenden Ansprüche, **dadurch gekennzeichnet, dass** die Stütz- und Führungsmittel (16) mehrere Befestigungsklammern (161), wobei jede der Befestigungsklammern (161) an einem Rahmen (14) der Vorrichtung (10) befestigt ist, und mehrere Befestigungsklauen (162) umfassen, wobei jede der Befestigungsklauen (162) am Touchscreen (12) befestigt ist, wobei die Befestigungsklauen (162) dazu konfiguriert sind, mit den Befestigungsklammern (161) zusammenwirken, um ein Einrasten des Touchscreens (12) am Rahmen (14) zu ermöglichen und die Verschiebung des Touchscreens (12) im Verhältnis zum Rahmen (14) in einer Richtung (Dz) senkrecht zur Vibrationsebene (P) zu verhindern, während gleichzeitig eine Führung des Touchscreens (12) während seiner Translationsverschiebung gegenüber dem Rahmen (14) in die Verschiebungsrichtung (Dx) gewährleistet wird.

8. Steuervorrichtung (10) nach Anspruch 7, **dadurch gekennzeichnet, dass** die Befestigungsklaue (162) an ihrem freien Ende einen Vorsprung (164) aufweist und dass jede Befestigungsklammer (161) mit zwei in der Vibrationsebene (P) und in einer Richtung (Dy) senkrecht zur Verschiebungsrichtung (Dx) elastisch verformbaren Laschen (165) versehen ist, wobei die Laschen (165) dazu konfiguriert sind, eine Durchgangsöffnung zu bilden, durch die die Befestigungsklaue (162) eingeführt werden kann, wobei die Durchgangsöffnung in einem unverformten Zustand der Befestigungsklammer (161) den Durchgang des Vorsprungs (164) der Befestigungsklaue (162) nicht zulässt.

9. Steuervorrichtung (10) nach einem der vorhergehenden Ansprüche, **dadurch gekennzeichnet, dass** die Steuereinheit dazu konfiguriert ist, die von dem mindestens einen Aktor (30) erzeugte haptische Rückmeldung in Abhängigkeit von der Intensität eines vom Benutzer auf mindestens eine der Steuerzonen (18) ausgeübten Drucks zu variieren.

10. Kraftfahrzeug, das eine Steuervorrichtung (10) nach einem der vorhergehenden Ansprüche umfasst.

## Claims

1. A control device (10) intended to control a function of a motor vehicle, the control device (10) comprising:
- a touch panel (12) comprising an outer surface provided with one or several control areas (18) each assigned to a specific function of the motor vehicle, the touch panel (12) supporting one or several elementary sensors (20) each positioned in vertical alignment with one of said control areas (18), said elementary sensor(s) (20) being likely to generate at least one signal in response to an action applied by the user on at least one of said control areas (18),
- at least one actuator (30) configured to provide a user with haptic feedback by a translational displacement of the touch panel (12) in a plane (P), called the vibration plane, and in a single displacement direction (Dx),
- a monitoring unit configured to receive said at least one signal generated by said elementary sensor(s) (20) and to monitor said at least one actuator (30) in response to said signal,
said control device (10) including support and guide means (16) intended to maintain the touch panel (12) aligned in the vibration plane (P) and being **characterized in that** each of the elementary sensors (20) comprises at least one insulating substrate (210) on which are deposited conductive tracks (221, 222) forming at least one capacitive sensor and an assembly (230) of conductive or semiconductive nanoparticles in a colloidal suspension in an electrically insulating ligand, said assembly (230) forming at least one force sensor.

2. The control device (10) according to claim 1, **characterized in that** at least one of the control areas (18) forms a portion of the outer surface of the touch panel (12) on which a user's finger can rest, said at least one control area (18) being disposed contiguously to one of the elementary sensors (20) so that pressing on said at least one control area (18) generates a deformation of said elementary sensor (20) which can be detected by the force sensor of said elementary sensor (20).

3. The control device (10) according to any of the preceding claims, **characterized in that** said at least one actuator (30) comprises a fixed part (31, 34) connected to a frame (14) of the device (10) and a movable part (32, 35) in an air gap of the fixed part (31, 34), the movable part (32, 35) being connected to the touch panel (12).

4. The control device (10) according to claim 3, **characterized in that** the movable part of said at least one actuator (30) comprises a magnet or an array of magnets (35) and the fixed part of said at least one actuator (30) comprises a coil or an array of coils (34).

5. The control device (10) according to claim 3, **characterized in that** said at least one actuator (30) comprises a rotary motor provided with a rotating shaft, the rotating shaft constituting the movable part of said at least one actuator.

6. The control device (10) according to claim 3, **characterized in that** said at least one actuator (30) comprises a translational inertial actuator.

7. The control device (10) according to any of the preceding claims, **characterized in that** the support and guide means (16) comprise several fastening clips (161), each of the fastening clips (161) being secured to a frame (14) of the device (10), and several fastening lugs (162), each of the fastening lugs (162) being secured to the touch panel (12), the fastening lugs (162) being configured to cooperate with the fastening clips (161) to allow clipping of the touch panel (12) on the frame (14) and to prevent the displacement of the touch panel (12) relative to the frame (14) in a direction (Dz) perpendicular relative to the vibration plane (P) while ensuring guiding of said touch panel (12) during its translational displacement relative to the frame (14) in the displacement direction (Dx).

8. The control device (10) according to claim 7, **characterized in that** the fastening lug (162) has a protrusion (164) at its free end and **in that** each fastening clip (161) is provided with two tabs (165) elastically deformable in the vibration plane (P) and in a direction (Dy) perpendicular to the displacement direction (Dx), said tabs (165) being configured to form a passage opening through which the fastening lug (162) can be inserted, said passage opening not allowing, in an undeformed state of the fastening clip (161), the passage of the protrusion (164) of the fastening lug (162).

9. The control device (10) according to any of the preceding claims, **characterized in that** the monitoring unit is configured to vary the haptic feedback generated by said at least one actuator (30) as a function of the magnitude of a pressure exerted by the user on at least one of said control areas (18).

10. A motor vehicle comprising a control device (10) according to any of the preceding claims.
